Europäisches Patentamt

European Patent Office

Office européen des brevets

(19)

(11) Numéro de publication : **0 317 421 B1**

## FASCICULE DE BREVET EUROPEEN

(12)

(45) Date de publication du fascicule du brevet :
**22.01.92 Bulletin 92/04**

(51) Int. Cl.⁵ : **H03M 1/12**

(21) Numéro de dépôt : **88402862.2**

(22) Date de dépôt : **15.11.88**

(54) **Convertisseur analogique-numérique rapide a structure parallèle.**

(30) Priorité : **20.11.87 FR 8716073**

(43) Date de publication de la demande :
**24.05.89 Bulletin 89/21**

(45) Mention de la délivrance du brevet :
**22.01.92 Bulletin 92/04**

(84) Etats contractants désignés :
**DE GB IT NL**

(56) Documents cités :
**EP-A- 0 101 571**
**FR-A- 2 536 923**

(56) Documents cités :
**IEEE INTERNATIONAL SOLID-STATE CIR-
CUITS CONFERENCE, vol. 28, conférence 32,
13 février 1985, pages 34-35,298-299, IEEE,
Coral Gables, Florida, US; T. TSUKADA et al.:
"GMOS 8b 25MHz flash ADC"**

(73) Titulaire : **THOMSON COMPOSANTS
MILITAIRES ET SPATIAUX
173, Bd Haussmann
F-75008 Paris (FR)**

(72) Inventeur : **Masson, Thierry
Thomson - CSF SCPI 19, avenue de Messine
F-75008 Paris (FR)**

(74) Mandataire : **Guérin, Michel et al
THOMSON-CSF SCPI
F-92045 PARIS LA DEFENSE CEDEX 67 (FR)**

EP 0 317 421 B1

## Description

L'invention concerne un convertisseur analogique-numérique rapide à structure parallèle.

On entend par convertisseur analogique-numérique rapide à structure parallèle un convertisseur tel que représenté sur la figure 1. Le document FR-A-2536923 en décrit un exemple.

Pour obtenir une conversion rapide, le convertisseur possède $2^n$ comparateurs identiques au comparateur 10 fonctionnant en parallèle, n étant le nombre de bits de sortie de convertisseur. Chaque comparateur reçoit d'une part la tension analogique Vin à convertir en une valeur numérique binaire de n bits et d'autre part une tension de référence respective qui est une fraction, exprimée en multiples de $1/2^n$, d'une tension de référence générale Vréf. Ainsi, par exemple pour un convertisseur huit bits ($2^8 = 256$), le premier comparateur reçoit comme tension de référence Vréf/256, le deuxième 2Vréf/256, le troisième 3 Vréf/256 etc.., jusqu'au dernier qui reçoit Vréf.

Les comparateurs fournissent chacun un niveau logique de sortie binaire indiquant si la tension vin est supérieure ou inférieure à leur tension de référence respective.

Les sorties de tous les comparateurs sont appliquées à un circuit logique de décodage 20. Celui-ci reçoit donc $2^n$ signaux logiques qui, si on les examine successivement, se présentent sous forme d'une série de signaux logiques à un premier niveau (pour tous les comparateurs dont la tension de référence est inférieure à la tension à convertir), suivie d'une série de signaux logiques à un deuxième niveau (pour tous les autres comparateur). Le circuit de décodage détermine la position du changement de niveau logique dans cette double série et fournit un mot de n bits représentant cette position, ou éventuellement une indication de dépassement de capacité du convertisseur.

Les tensions de référence sont établies à l'aide d'un pont diviseur résistif de grande précision, formé de $2^n$ résistances en série, de valeur commune R et alimenté par la tension de référence globale Vréf ; une prise intermédiaire est prévue à chaque point de jonction de deux résistances R et cette prise est reliée à une entrée d'un comparateur respectif pour lui amener une tension de référence correspondante qui est une fraction, multiple de $1/2^n$, de Vréf.

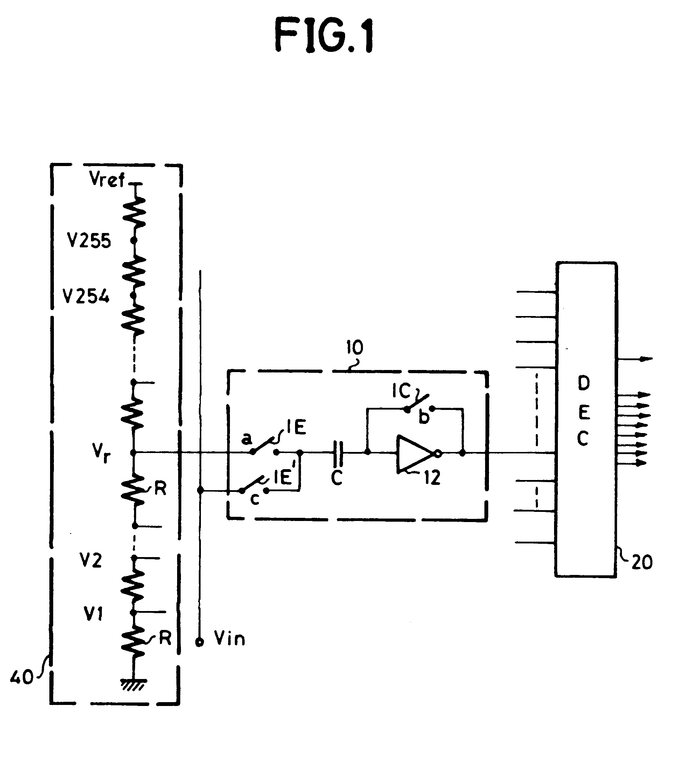

Sur la figure 1, représentant schématiquement un convertisseur à huit bits, les tensions de référence sont désignées par V1, V2... Vr,... V255, Vréf. Un seul comparateur 10 a été représenté, recevant une tension de référence Vr.

En technique de circuits intégrés, on travaille avec de faibles tensions et la tension de référence Vréf peut ne pas dépasser 2 volts. Par conséquent le pas élémentaire entre deux tensions de référence consécutives est de 2/256 volts soit environ 8 millivolts. Il est donc impératif que l'on utilise comme comparateurs des amplificateurs différentiels à très faible tension de décalage à l'entrée, faute de quoi la comparaison n'aurait pas de signification.

C'est pourquoi on utilise des comparateurs associés à une capacité qui prend en mémoire la tension de décalage et la restitue en l'additionnant à la différence des tensions à comparer de telle sorte que le basculement du comparateur ne résulte que du signe de cette différence quelle que soit la valeur de la tension de décalage.

Le comparateur unique 10 représenté à la figure 1 est un comparateur de ce type, à élimination de tension de décalage. Il comprend un amplificateur-inverseur 12, une capacité d'entrée C dont une borne est reliée à l'entrée de l'amplificateur et des moyens de commutation (interrupteurs IE, IE', IC pouvant être des transistors à effet de champ à grille isolée) commandés par un circuit logique de commande non représenté.

L'interrupteur IE permet de relier à l'autre borne de la capacité C la tension de référence Vr correspondant à ce comparateur ;

L'interrupteur IE' permet de relier à cette autre borne de la capacité C la tension analogique Vin à convertir ;

L'interrupteur IC permet de boucler en court-circuit la sortie de l'amplificateur 12 sur son entrée.

Le circuit logique de commande de commutation fonctionne périodiquement selon essentiellement deux phases.

Dans une première phase a l'interrupteur IE est fermé ; en dehors, il reste ouvert.

Dans une deuxième phase c, l'interrupteur IE' est fermé ; en dehors, il reste ouvert. En pratique, les phases a et c sont complémentaires.

A l'intérieur de l'une de ces phases, en pratique durant une phase b qui coïncide essentiellement avec la première phase a mais qui doit impérativement se terminer légèrement avant elle, l'interrupteur IC est fermé. La phase b pourrait aussi à la rigueur coïncider avec la phase c et non la phase a.

En pratique la phase b coïncide avec la phase a. La phase a est appliquée sur tous les comparateurs en même temps de sorte que la capacité C de chacun prenne une charge C (Vr-Vs), Vs étant la tension de décalage de l'inverseur 12. Cette phase permet donc de prendre en compte la tension de décalage de chaque inverseur 12. Cette phase est classiquement appelée phase d'auto-zéro

Il faut bien évidemment que cette phase soit appliquée à tous les comparateurs avant que la tension à convertir Vin ne soit appliquée cette dernière étant appliquée durant la phase c. Ainsi chaque comparateur est prêt à recevoir la tension Vin et bascule ou non, sans altération dues aux conditions initiales dans lesquelles il se trouve, lorsque cette tension Vin est appliquée.

Des problèmes nouveaux se posent maintenant à l'homme de métier qui cherche à réaliser des convertisseurs rapides de plus grande résolution que la résolution obtenue par les convertisseurs existants. En effet, l'homme de métier rencontre des difficultés de réalisation dès qu'il cherche à obtenir des convertisseurs de plus de huit bits notamment en technologie MOS.

La démarche usuelle consiste, tout d'abord, pour augmenter la rapidité des convertisseurs, à augmenter la taille des transistors qui réalisent la fonction d'inverseur. Or cette augmentation de taille provoque une augmentation de consommation du courant qui n'est pas gênante en soi mais qui le devient lorsque à cela se rajoute une augmentation de la consommation, due à une augmentation du nombre de comparateurs. En effet, pendant la phase b (qui en pratique correspond à la phase a) l'interrupteur C est fermé pour tous les comparateurs. Ces comparateurs sont ainsi rebouclés en gain unité ce qui correspond à leur point de consommation maximale, la consommation étant d'autant plus élevé que les comparateurs sont plus rapides et plus sensibles. Par ailleurs, pendant la phase b, on branche les $2^n$ comparateurs et les $2^n$ capacités sur le pont de résistances. Tout d'abord cela introduit des perturbations dynamiques sur le pont, et le pont ne retrouve son état initial qu'après un temps relativement long, qui est d'autant plus long que le nombre de comparateurs est plus grand.

Par conséquent, en pratique, l'homme de métier ne peut pas réaliser des convertisseurs analogiques-numériques rapides, parallèles de plus de huit bits en technologie MOS.

L'invention permet de remédier à ces problèmes d'une manière inattendue, en n'opérant plus, comme cela se fait usuellement, en une phase a unique et synchrone pour tous les comparateurs mais en des phases $a_1$, $a_2$... $a_p$ ($p = 2^n$) appliquées de façon séquentielle à un ou plusieurs comparateurs à la fois sans que cela ne provoque une altération du résultat de conversion. Ainsi, les comparateurs donnent continuellement la position du signal d'entrée Vin, et l'on vient prendre des informations logiques au rythme d'une horloge indépendante des phases a1, a2... ap, chaque comparateur ayant une phase d'auto-zéro qui lui est propre.

Un objet de la présente invention consiste donc à réaliser un convertisseur analogique — numérique destiné à transformer une tension analogique en une tension numérique de n bits, comportant :

— un générateur de tension de référence ;

— $2^n$ comparateurs aptes à comparer la tension analogique à une tension de référence chaque comparateur comprenant un amplificateur inverseur, une capacité ayant une première borne reliée à l'entrée de l'amplificateur ;

— des moyens de décodage des signaux délivrés par les comparateurs ;

— des moyens de commutation et un circuit logique de commande de ces moyens fonctionnant périodiquement selon le cycle suivant :

— pendant une première phase (a) de chaque période l'amplificateur est bouclé en court-circuit tandis que la tension de référence est appliquée à l'autre borne de la capacité ;

— pendant une deuxième phase (c), l'amplificateur n'est plus bouclé en court-circuit, et la tension analogique est appliquée à l'autre borne de la capacité ; le convertisseur étant principalement caractérisé en ce que :

— à un instant donné un ou plusieurs comparateurs se trouvent dans la première phase (a) alors que tous les autres se trouvent dans la deuxième phase (c) ; de manière à ce que successivement chaque comparateur passe par cette première phase alors que les autres se trouvent dans la deuxième phase (c) ; le convertisseur étant également caractérisé en ce que le circuit logique de commande comporte des moyens de génération de signaux d'horloge pour séquencer le passage de chaque comparateur dans la première phase (a) puis dans la deuxième phase (c) par activation des moyens de commutation.

Un autre objet de l'invention consiste à réaliser un convertisseur analogique-numérique dans lequel le générateur de tension de référence est réalisé par un pont de résistances de précision.

Un autre objet de l'invention consiste à réaliser un convertisseur analogique numérique dans lequel le générateur de tension est réalisé par un convertisseur numérique-analogique de m bits m étant supérieur à n, ce convertisseur étant commandé par un compteur numérique qui est piloté par les moyens de génération d'horloge. Un autre objet de l'invention consiste à réaliser un convertisseur analogique-numérique dans lequel les moyens de génération d'horloge sont réalisés par un registre à décalage dont la sortie attaque l'entrée et qui est piloté par une horloge externe.

L'invention a également pour objet un convertisseur analogique-numérique dans lequel les moyens de décodage comportent $2^n$ bascules recevant chacune le signal de sortie d'un comparateur et délivrant ce signal au rythme d'une horloge externe, le résultat de sortie de chaque bascule étant forcé à un état donné lorsque cette bascule est reliée à un comparateur qui se trouve dans la phase a de fonctionnement (auto-zéro) pendant que tous les autres se trouvent dans la phase c.

L'invention a également pour objet un convertisseur analogique-numérique dans lequel les moyens de décodage comportent en outre des portes logiques reliant les sorties des bascules trois à trois pour permettre la détection d'une transition d'état afin de connaître le codage binaire de la tension d'entrée Vin.

D'autres particularités et avantages de l'invention apparaîtront mieux à la lecture de la description détaillée qui suit et se réfère aux figures annexées dans lesquelles :

— La figure 1, déjà décrite représente un convertisseur analogique-numérique selon l'art antérieur ;

— la figure 2, un convertisseur analogique-numérique selon l'invention ;

— la figure 3, les différents signaux d'horloge et en particulier les phases de commutation des commutateurs ;

— la figure 4, un mode de réalisation d'un décodeur 20 selon l'invention ;

— la figure 5, un deuxième mode de réalisation de générateur de tension de référence ;

— la figure 6a et 6b, un exemple de réalisation de générateur d'horloge selon l'invention selon deux configurations possibles.

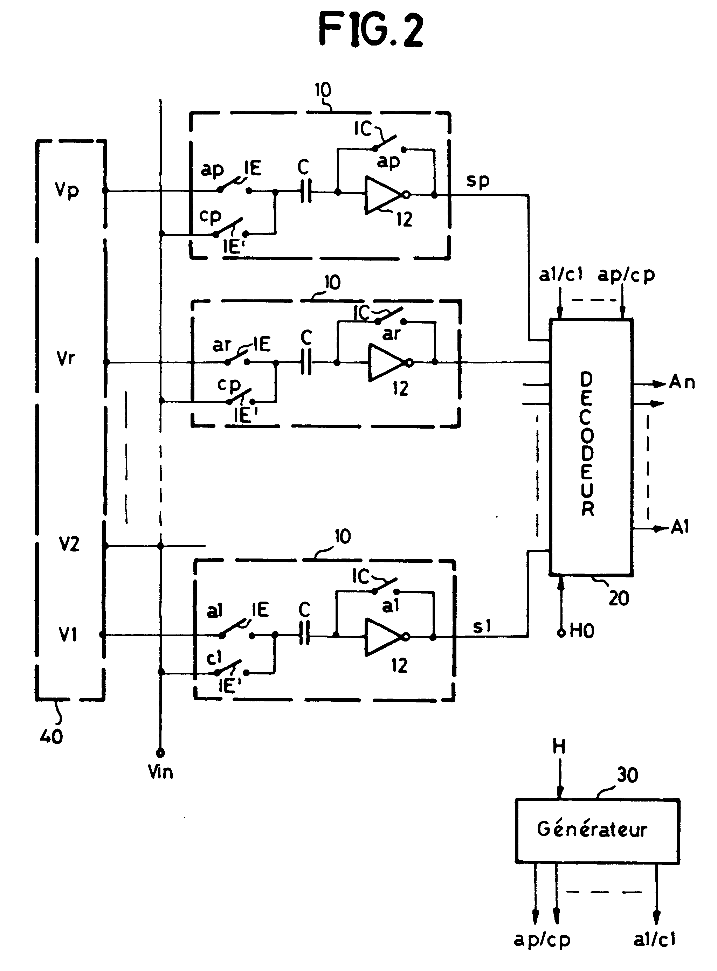

Sur la figure 2, on a représenté un convertisseur analogique-numérique, dans lequel on retrouve des comparateurs 10 comprenant une capacité C pouvant être reliée par une première borne à une tension de référence Vr par l'intermédiaire d'un premier commutateur IE, ou à la tension analogique Vin par l'intermédiaire d'un deuxième commutateur IE′. La deuxième borne de la capacité C est reliée à l'entrée d'une porte inverseuse 12. La sortie de la porte est rebouclée à l'entrée par l'intermédiaire d'un commutateur IC. La sortie de chaque porte 12 est reliée à une entrée d'un décodeur 20 qui délivre en sortie au rythme d'une horloge externe HO, la tension numérisée correspondant à la tension analogique Vin.

Sur cette figure on a représenté à titre d'exemple p niveaux de référence allant de V1 à Vp, Vref étant la référence globale générale, p étant égal 1024, ce qui correspond à 1024 niveaux, et ce qui permet d'avoir une conversion sur 10 bits ($2^{10} = 1024$). Chaque niveau est un niveau de référence auquel est comparée la tension analogique Vin. Le premier comparateur 10 comparera donc la tension Vin à la tension de référence V1 qui est égale Vref/1024, la tension V2 = 2 Vref/1024. Ces niveaux de référence sont obtenus par un générateur de tension 40 à partir de la référence générale Vréf.

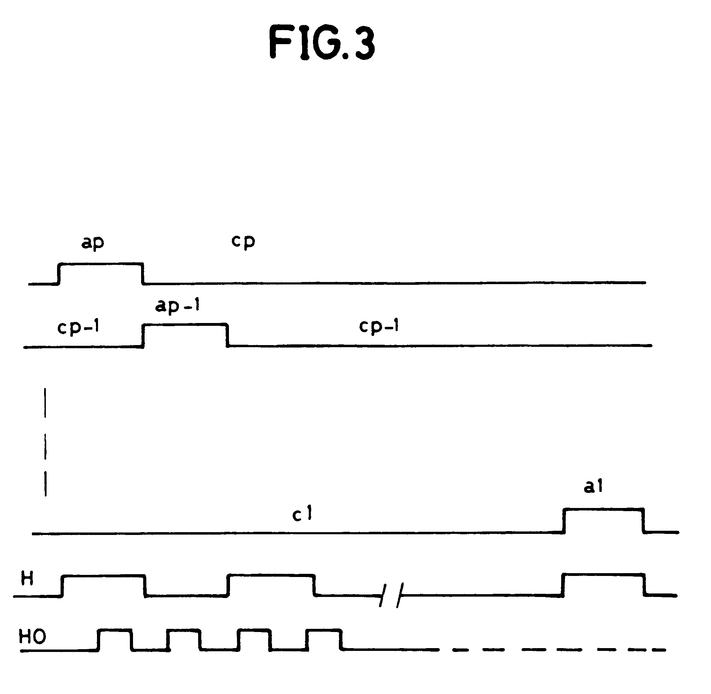

Les conversions sont faites au rythme de l'horloge HO qui est une horloge externe donnée par l'utilisateur. Une autre H horloge permet à un générateur 30 de fournir des signaux d'horloge représentés sur la figure 3 correspondant aux phases de fonctionnement respectivement a1/c1, a2/c2... ap/cp se traduisant par le stockage périodique de la tension de décalage de chaque comparateur. Chaque comparateur fonctionne périodiquement suivant le cycle suivant :

— pendant une première phase a (soit a1 pour le premier comparateur 10, $a_p$ pour le pième comparateur, de chaque période, l'amplificateur est bouclé en court-circuit tandis que la tension de référence est appliquée à l'autre borne de la capacité ;

— pendant une deuxième phase c, l'amplificateur n'est plus bouclé en court-circuit, et la tension analogique Vin est appliquée à l'autre borne de la capacité, cet amplificateur suit continuellement l'évolution de la tension analogique Vin.

Pendant que le premier comparateur se trouve dans la phase a1, les autres comparateurs se trouvent dans la phase c, si bien que durant la phase a1, l'amplificateur bouclé sur lui-même présente à son entrée une tension qui est égale à sa tension de seuil (encore appelée tension de décalage) Vs.

L'interrupteur IE étant fermé et l'interrupteur IE′ ouvert, la capacité C prend une charge C (Vs-V1) alors que pendant ce temps toutes les capacités des autres comparateurs reçoivent sur une borne la tension Vin et sur l'autre borne la tension appliquée à l'entrée de l'amplification cette tension n'étant plus la tension Vs mais une tension Ve. Durant cette phase le commutateur est fermé.

A la fin de la phase a1 la charge stockée reste stockée sur la borne de la capacité qui est reliée à l'entrée de l'amplificateur. En effet l'impédance d'entrée de l'amplificateur étant élevée, aucun écoulement ne peut avoir lieu.

La phase c1 est alors appliquée à ce premier amplificateur pendant que la phase a2 est appliquée au deuxième amplificateur. L'interrupteur IE étant fermé et l'interrupteur IE′ ouvert, la capacité C de ce deuxième comparateur prend une charge C(Vs-V2) alors que pendant ce temps tous les interrupteurs IE des autres comparateurs sont ouverts et les interrupteurs IE′ sont fermés.

Successivement la tension appliquée à une borne de la capacité de chaque comparateur passe d'une tension de reference V1 pour le premier..., V1024 pour le dernier, à la tension Vin. D'après la répartition des charges qui a lieu lorsque l'on passe d'une phase a à une phase c, la somme des charges stockées restant constante, le sens du basculement du comparateur ne dépend que du signe de la différence Vin-V1, Vin-V2 etc, la tension de seuil n'ayant d'après cette configuration connue de chaque comparateur aucune influence.

Le décodeur 20 délivre la tension décodée à la cadence de l'horloge HO, indépendante des différentes phases.

Ainsi un seul comparateur se trouve au point de consommation maximale, ce comparateur étant celui qui se trouve dans la phase a. Les autres comparateurs ne consomment que si la tension analogique Vin est proche de la tension de référence associée. La consommation totale se trouve fortement diminuée par rapport à l'art antérieur. Ceci peut permettre notamment d'augmenter le courant pour améliorer la vitesse du convertisseur.

Le décodeur 20 est également activé par les signaux de phase a1, a2... ap. Lorsqu'un compara-

teur r se trouve en phase $a_r$, l'état de la sortie du décodeur correspondant à l'état du rième comparateur est forcé par cette phase $a_r$. On force l'état de sortie du comparateur qui se trouve durant la a (a1, a2... ap) à un état prédéterminé qui est toujours un "1" ou toujours un "0") pour détecter à quel endroit se produit la transition c'est-à-dire le passage d'une série d'états logiques identiques à une autre série d'états identiques mais complémentaires et connaître les n bits de codage de la tension analogique.

En forçant l'état de la sortie du comparateur qui se trouve durant la phase a alors qu'a lieu une conversion, et en associant des portes logiques ET à trois entrée à la sortie des bascules qui figent l'état de sortie des comparateurs, on minimise les erreurs de codage que pourrait entraîner l'application successive d'une phase a à chaque comparateur alors qu'une phase de conversion à lieu pour les autres comparateurs. Les portes logiques ET sont réalisées au moyen d'une porte NON-ET 22 à trois entrées suivie d'une porte inverseuse 23. Par exemple la bascule associée au nième comparateur délivre le signal Bn appliqué à une entrée de la porte 22 associée, qui reçoit sur une autre entrée le signal Bn – 1 et sur une autre entrée le signal Bn + 1 (obtenu par la porte 24). Un démultiplexeur 25 à $2^n$ entrées et n sorties délivre les signaux A1-An correspondant aux n bits de codage de la tension Vin.

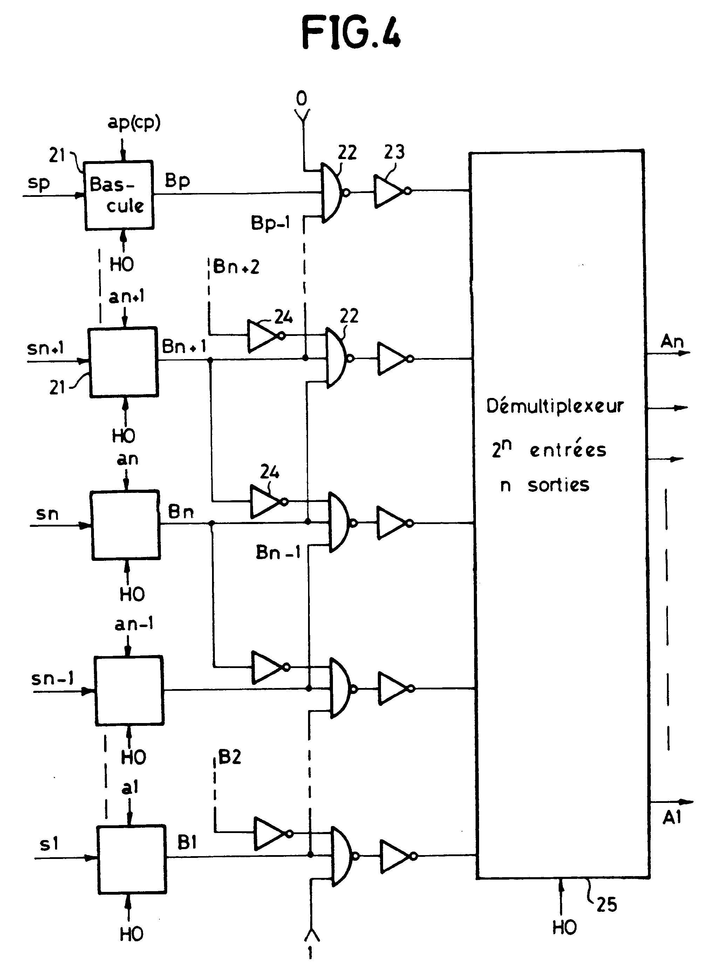

Le détail de réalisation d'un tel décodeur est donné sur la figure 4.

Dans le cas ou l'état que l'on force est un "1" logique, le décodeur doit détecter une transition lorsque les états O11 apparaissent dans cet ordre. Dans le cas ou l'état que l'on force est un "O" logique, le décodeur doit détecter une transition lorsque les états OO1 apparaissent dans cet ordre.

Dans le cas ou l'on a forcé a "1", l'état d'un comparateur pour lequel la tension de référence est différente de la tension analogique Vin, la sortie de la bascule qui est reliée à ce comparateur délivre un "1" alors que les bascules reliées aux autres comparateurs qui ont également une tension de référence différente de la tension analogique Vin délivrent toutes un "0" (ou tous un "1") le décodeur ne génère pas de code faux car on ne peut pas avoir la transition 011 au niveau de ce comparateur. Le forçage à "1" de la bascule et le décodage au moyen des portes ET à au moins trois entrées empêchent l'introduction d'une erreur de codage. Bien entendu si l'état que l'on impose à la bascule est "0", la transition que l'on détecte est alors la succession des états 001, le forçage a "0" empêche pour les mêmes raisons l'introduction d'un erreur de codage.

Dans le cas ou l'on a forcé à "1" l'état d'un comparateur pour lequel la tension de référence est proche de la tension analogique Vin, la sortie de la bascule qui est reliée à ce comparateur délivre un "1" pendant que la bascule du comparateur qui a une tension de référence égale à la tension analogique Vin délivre également un "1" et pendant que les comparateurs qui ont une tension de référence supérieure à cette tension analogique Vin délivrent un "0" (ou un "1"), et pendant que tous les comparateurs qui ont une tension de référence inférieure à cette tension Vin délivrent un "1" (ou un "0"). Le décodeur détecte une transition par la présence des états successifs 011 alors que le premier état "1" rencontré ne correspond pas obligatoirement à un "1", cet état ayant été forcé. Il se peut donc uniquement dans ce cas (cas qui se produit lorsque le comparateur qui se trouve dans une phase a, a une tension de référence proche de la tension analogique Vin) qu'il y ait une erreur de codage. Si cette erreur se produit, elle ne porte que sur le bit de poids faible $Vref/2^n$ et uniquement lorsque le signal se trouve au niveau de la tension de référence du comparateur dans la phase a. Cette erreur devient négligeable dès lors que la résolution est grande par exemple lorsque n est supérieur ou égal à 6 comme c'est le cas avec le convertisseur.

Comme cela est représenté sur la figure 1, les tensions de références peuvent être obtenues au moyen d'un pont de résistances de précision, comme un seul comparateur a la fois est connecté au pont, les problèmes de perturbation dynamique sont éliminés.

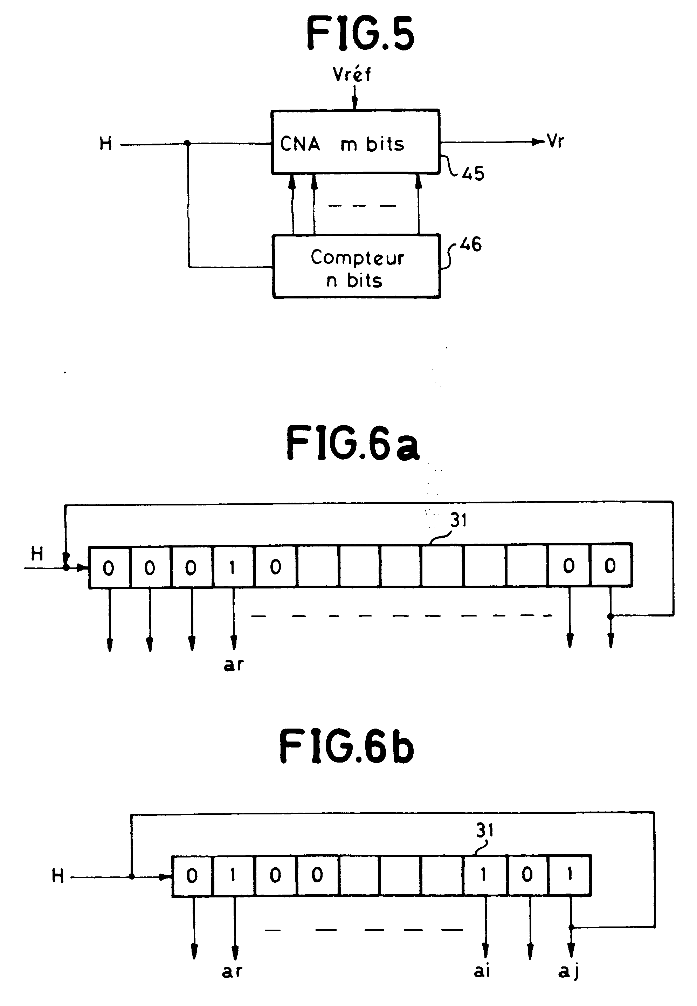

On peut également obtenir des niveaux de tension de référence d'une très grande précision au moyen d'un circuit comportant un convertisseur numérique-analogique tel que représenté sur la figure 5. Le convertisseur utilisé a préférentiellement une résolution supérieure à la résolution du convertisseur analogique numérique réalisé soit n bits (m > n, m = 12 bits par exemple). Le convertisseur est piloté par un compteur numérique de n bits. Les (m-n) bits de poids faibles du convertisseur numérique-analogique sont inutilisés et sont pour cela par exemple mis à zéro. Le convertisseur et le compteur sont pilotés par l'horloge H. Le compteur est déclenché par l'horloge H, chaque incrémentation du compteur correspond en sortie du convertisseur numérique-analogique à un niveau de tension de référence pour le comparateur se trouvant dans la phase a. Lorsque le compteur a atteint $2^n$ (1024), tous les niveaux de référence ont été délivrés le cycle de génération des niveaux de référence recommence.

Sur la figure 6a, on a représenté un premier mode de réalisation de générateur d'horloge selon l'invention.

Le générateur 30 est constitué par un registre à décalage 31 dans lequel un état logique "1" par exemple circule, tous les autres états étant des zéro. Le registre 31 est piloté par l'horloge H. Chaque étage de sortie du registre correspond à un signal d'activation des commutateurs IE et IC d'un comparateur donné. La sortie du dernier étage du registre est rebouclée sur l'entrée. On peut également utiliser un diviseur par $2^n$ à l'entrée du registre 31, au lieu de connecter la sortie du registre sur son entrée. A chaque passage de l'état logique "1" dans un étage, l'étage contenant cet état délivre un signal qui correspond à la première phase $a_r$ de fonctionnement de chaque comparateur. On obtient donc à la sortie du premier étage, par exemple, la phase a1, puis successivement à la sortie du dernier étage, la phase $a_p$.

Dans le cas ou plusieurs comparateurs se trouvent dans la première phase de fonctionnement, le générateur doit générer plusieurs signaux synchrones (le même nombre que de comparateurs se trouvant dans la première phase) correspondant à une première phase de fonctionnement $a_r$, $a_i$, $a_j$ pour ces comparateurs. Pour cela comme le montre la figure 6b, le registre 31 comporte plusieurs états logique "1" qui circulent. Chaque étage de sortie du registre correspond également à un signal d'activation des commutateurs. A chaque passage d'un état logique "1", le signal de sortie correspond à une phase $\underline{a}$ de fonctionnement pour les comparateurs.

l'invention permet donc de diminuer la consommation puisque un seul ou seulement quelques amplificateurs du convertisseur se trouvent bouclés en gain unité. Elle permet également, lorsque le générateur de tensions de référence est réalisé par un pont de résistances, de supprimer pratiquement toutes les perturbations sur le pont. Elle permet par conséquent de réaliser des convertisseurs de résolution supérieure à 8 bits ce qui n'était pas possible avec la technique antérieure. Elle permet aussi d'utiliser un convertisseur numérique-analogique à la place d'un pont de résistances pour avoir une plus grande précision sur les tensions de référence.

D'autre part, au lieu de n'avoir qu'un seul comparateur à la fois en phase $\underline{a}$, on peut mettre jusqu'à une dizaine de comparateurs en état de fonctionnement correspondant à la phase $\underline{a}$. Bien entendu ce nombre doit être faible par rapport à 1024 si le convertisseur comporte 1024 comparateurs.

L'invention s'applique notamment à des circuits utilisant des transistors à effet de champ et à grille isolée (MOS, MESFET).

## Revendications

1. Convertisseur analogique-numérique destiné à transformer une tension analogique (Vin) en une tension numérique de n bits comportant :

— $p = 2^n$ comparateurs (10) aptes à comparer la tension analogique (Vin) à une tension de référence analogique (V1, V2,... Vr, Vp) obtenue par un générateur de tension (40), chaque comparateur (10) comprenant un amplificateur inverseur (12), une capacité (C) ayant une première borne reliée à l'entrée de l'amplificateur ;

— des moyens de décodage (20) des signaux délivrés par les comparateurs ;

— des moyens de commutation (IE, IE, IC) et un circuit logique de commande de ces moyens fonctionnant périodiquement selon le cycle suivant :

— pendant une première phase (a) de chaque période l'amplificateur est bouclé en court-circuit tandis que la tension de référence (Vr) est appliquée à l'autre borne de la capacité ;

— pendant une deuxième phase (c), l'amplificateur (12) n'est plus bouclé en court-circuit et la tension analogique (Vin) est appliquée à l'autre borne de la capacité ; le convertisseur étant caractérisé en ce que :

— à un instant donné un ou plusieurs comparateurs (10) se trouvent dans la première phase (a) alors que tous les autres se trouvent dans la deuxième phase ; de manière à ce que successivement chaque comparateur ou chaque groupe de plusieurs comparateurs passent par cette première phase (a) alors que tous les autres se trouvent dans la deuxième phase (c) ;

— et en ce que le circuit logique de commande comporte des moyens de génération (30) de signaux d'horloge (a1, a2... ap ; b1, b2, b2... bp) pour séquencer le passage de chaque comparateur dans la première phase (a) puis dans la deuxième phase (b) par activation des moyens de commutation (IE, IE, IC).

2. Convertisseur analogique-numérique selon la revendication 1, caractérisé en ce que le générateur de tension de référence (40) est constitué d'un pont de résistance (R) de précision.

3. Convertisseur analogique- numérique selon la revendication 1, caractérisé en ce que le générateur de tension de référence (40) est constitué par un convertisseur analogique-numérique (45) de m bits, m étant supérieur à n, piloté par un compteur numérique (46) de n bits.

4. Convertisseur analogique-numérique selon l'une quelconque des revendications 1 à 3, caractérisé en ce que les moyens de génération de signaux d'horloge (30) sont constitués par un registre à décalage (31) à l'intérieur duquel circule un état logique correspondant à une première phase de fonctionnement ($a_r$) pour le comparateur relié à la sortie de l'étage qui contient cet état, chaque sortie du registre étant reliée à un comparateur, la sortie du dernier étage de ce registre étant rebouclée sur l'entrée du registre (31).

5. Convertisseur analogique-numérique selon l'une quelconque des revendications 1 à 3, caractérisé en ce que les moyens de génération de signaux d'horloge (30) sont constitués par un registre à décalage (31) à l'intérieur duquel circulent plusieurs états logiques correspondant à une première phase de fonctionnement ($a_r$, $a_i$, $a_j$) pour les comparateurs reliés aux sorties des étages qui contiennent ces états, chaque sortie du registre étant reliée à un comparateur, la sortie du dernier étage de ce registre étant rebouclée sur l'entrée du registre (31).

6. Convertisseur analogique-numérique selon l'une quelconque des revendications 1 à 5, caractérisé en ce que le décodeur (20) comporte $2^n$ bascules (21) chaque bascule recevant le signal de sortie (sr) d'un comparateur (10) et un signal d'horloge correspondant à une première phase ($a_r$) ou à une deuxième phase ($c_r$) de fonctionnement du comparateur (10) ; la sortie de chaque bascule étant reliée à au moins une entrée d'une porte logique (22) à trois entrées ; et caractérisé en ce que le passage du signal d'horloge à une première phase force le signal de sortie de la bascule qui reçoit ce signal d'horloge à un état logique prédéterminé.

## Patentansprüche

1. Analog-Digital-Wandler zur Umwandlung einer analogen Spannung (Vin) in einen Digitalwert mit n Bits,
— mit p = $2^n$ Komparatoren (10), die in der Lage sind, die Analogspannung (Vin) mit einer analogen Bezugsspannung (V1, V2,... Vr, Vp) zu vergleichen, die von einem Spannungsgenerator (40) erzeugt wird, wobei jeder Komparator (10) einen Inverterverstärker (12) und einen Kondensator (C) aufweist, der mit einem ersten Ende an den Eingang des Verstärkers angeschlossen ist,
— mit Dekodiermitteln (20) zum Dekodieren der von den Komparatoren gelieferten Signale,
— mit Schaltmitteln (IE, IE', IC) und einem logischen Steuerkreis für diese Schaltmittel, der periodisch gemäß folgendem Zyklus arbeitet :
— während einer ersten Phase (a) jeder Periode ist der Verstärker im Kurzschluß rückgekoppelt, während die Bezugsspannung (Vr) an den anderen Anschluß des Kondensators angelegt ist ;
— während einer zweiten Phase (c) ist der Verstärker (12) nicht mehr im Kurzschluß rückgekoppelt, und die analoge Spannung (Vin) liegt am anderen Ende des Kondensators, dadurch gekennzeichnet, daß
— in einem gegebenen Zeitpunkt einer oder mehrere Komparatoren (10) sich in der ersten Phase (a) befinden, während alle anderen Komparatoren sich in der zweiten Phase befinden, derart, daß nacheinander jeder Komparator oder jede Gruppe von mehreren Komparatoren diese erste Phase (a) durchläuft, während alle anderen Komparatoren sich in der zweiten Phase (c) befinden,
— und daß der logische Steuerkreis Mittel (30) zur Erzeugung von Taktsignalen (a1, a2,... ap ; c1, c2,... cp) aufweist, um den Übergang jedes Komparators in die erste Phase (a) und dann in die zweite Phase (b) durch Aktivierung der Schaltmittel (IE, IE', IC) zu veranlassen.

2. Analog-Digital-Wandler nach Anspruch 1, dadurch gekennzeichnet, daß der Bezugsspannungsgenerator (40) von einer Präzisionswiderstandsbrücke (R) gebildet wird.

3. Analog-Digital-Wandler nach Anspruch 1, dadurch gekennzeichnet, daß der Bezugsspannungsgenerator (40) von einem Analog-Digital-Wandler (45) mit m Bits gebildet wird, wobei m größer als n ist und der Wandler von einem Digitalzähler (46) mit n Bits gesteuert wird.

4. Analog-Digital-Wandler nach einem beliebigen der Ansprüche 1 bis 3, dadurch gekennzeichnet, daß die Mittel zur Erzeugung der Taktsignale (30) von einem Schieberegister (31) gebildet werden, in dem ein logischer Zustand entsprechend einer ersten Betriebsphase ($a_r$) für denjenigen Komparator umläuft, der an den Ausgang der Stufe, die diesen Zustand aufweist, angeschlossen ist, wobei jeder Ausgang des Registers an einen Komparator angeschlossen ist und der Ausgang der letzten Stufe dieses Registers an den Eingang des Registers (31) zurückgeschleift ist.

5. Analog-Digital-Wandler nach einem beliebigen der Ansprüche 1 bis 3, dadurch gekennzeichnet, daß die Mittel zur Erzeugung von Taktsignalen (30) von einem Schieberegister (31) gebildet werden, in dem mehrere logische Zustände entsprechend einer ersten Betriebsphase ($a_r$, $a_i$, $a_j$) für diejenigen Komparatoren umlaufen, die an die Ausgänge der diese Zustände enthaltenden Stufen angeschlossen sind, wobei jeder Registerausgang an einen Komparator angeschlossen ist und der Ausgang der letzten Stufe dieses Registers an den Eingang des Registers (31) zurückgeschleift ist.

6. Analog-Digital-Wandler nach einem beliebigen der Ansprüche 1 bis 5, dadurch gekennzeichnet, daß der Dekodierer (20) $2^n$ Kippstufen (21) aufweist, die je das Ausgangssignal (sr) eines Komparators (10) sowie ein Taktsignal entsprechend einer ersten Betriebsphase ($a_r$) oder einer zweiten Betriebsphase ($c_r$) des Komparators (10) zugeführt erhalten, wobei der Ausgang jeder Kippstufe an mindestens einen Eingang eines logischen Tors (22) mit drei Eingängen angeschlossen ist, und dadurch gekennzeichnet, daß der Übergang des Taktsignals auf eine erste Phase das Ausgangssignal der Kippstufe, die dieses Taktsignal empfängt, in einem vorbestimmten logischen Zustand zwingt.

## Claims

1. An analog-to-digital converter intended to transform an analog voltage (Vin) into a digital value including n bits, the converter comprising
— p = $2^n$ comparators (10) conceived to compare the analog voltage (Vin) with an analog reference voltage (V1, V2,... Vr, Vp) produced by a voltage generator (40), each comparator (10) comprising an inverter-amplifier (12) and a capacitor (C) having a first terminal connected to the amplifier input,

— decoding means (20) for decoding the signals supplied by the comparators,

— switch means (IE, IE′, IC) and a logic control circuit for controlling these switch means to operate periodically according to the following cycle :

— during a first phase (a) of each period, the amplifier is looped by a short circuit while the reference voltage (Vr) is applied to the other terminal of the capacitor,

— during a second phase (c), the amplifier (12) is no more looped by a short circuit and the analog voltage (Vin) is applied to the terminal of the capacitor, characterized in that

— at a given instant, one comparator (10) is or several comparators are in the first phase (a), while all the other comparators are in the second phase, in such a way that, successively, each comparator or each group of several comparators transits through this phase (a) while all the others are in the second phase (c),

— and that the logic control circuit comprises means (30) for generating clock signals (a1, a2,... ap ; c1, c2,... cp) in order to make each comparator pass through the first phase (a) and then through the second phase (b) by activating the switch means (IE, IE′, IC).

2. An analog-to-digital converter according to claim 1, characterized in that the reference voltage generator (40) is constituted by a high precision resistor bridge (R).

3. An analog-to-digital converter according to claim 1, characterized in that the reference voltage generator (40) is constituted by an analog-to-digital converter (45) of m bits, m being greater than n and the comparator being controlled by a digital counter (46) of n bits counting capacity.

4. An analog-to-digital converter according to any one of claims 1 to 3, characterized in that the means for generating clock signals (30) are constituted by a shift register (31) in which a logic state according to a first operational phase ($a_r$) for that comparator circulates which is connected to the output of the stage containing this state, each register output being connected to one comparator, the output of the last stage of this register being fed back to the input of the register (31).

5. An analog-to-digital converter according to any one of claims 1 to 3, characterized in that the means for generating clock signals (30) are constituted by a shift register (31) in which several logic states corresponding to a first operational phase ($a_r$, $a_i$, $a_j$) for those comparators circulate which are connected to the output of the stages containing these states, each register output being connected to one comparator, the output of the last stage of this register being fed back to the input of the register (31).

6. An analog-to-digital converter according to any one of claims 1 to 5, characterized in that the decoder (20) comprises $2^n$ bistables (21), each bistable receiving the output signal (sr) of a comparator (C) and a clock signal corresponding to a first phase ($a_r$) or to a second phase ($c_r$) of operation of the comparator (10), the output of each bistable being connected to at least one input of a logic gate (22) having three inputs, and characterized in that the transition of the clock signal to a first phase forces the output signal of the bistable receiving this clock signal to a predetermined logic state.

# FIG.1

# FIG.2

# FIG.3

# FIG.4

# FIG.5

# FIG.6a

# FIG.6b